# DEMANDE DE BREVET EUROPEEN

(11) **EP 1 736 434 A2**
(43) Date de publication de la demande: **27.12.2006**
(21) Numéro de dépôt: 06114984.5
(22) Date de dépôt: 06.06.2006
(51) Int. Cl.: B81B 3/00, H01L 21/308

(54) **Procédé de fabrication d'objets sub-micrométriques suspendus et application à la caractérisation mécanique desdits objets**

(30) Priorité: 15.06.2005 FR 0551622
(71) Demandeur: Altis Semiconductor, 91105 Corbeil Essonnes Cedex (FR)
(72) Inventeur: Vekeman, Pierre, 77310 Boissise le Roi (FR); Lefevre, Sidonie, 92290 Chatenay Malabry (FR); Hoc, Thierry, 94240 L'Hay les Roses (FR); Deconinck, Pascal, 01309 Dresden (DE)
(74) Mandataire: Feray, Valérie

(57) **Abrégé**

L'invention concerne un procédé de fabrication d'objets sub-micrométriques comportant les étapes suivantes :
- dépôt d'une couche d'évidement (24) sur un support (20),
- dépôt d'une couche de transfert (26) sur ladite couche d'évidement (24),
- réalisation desdits objets (38) dans ladite couche de transfert,
- réalisation d'un masque dur (40, 42) sur une partie de ladite couche de transfert (26) afin de délimiter une zone (44) comprenant une partie desdits objets, et
- gravure de l'ensemble formé par ledit masque dur, la couche de transfert et la couche d'évidement de façon à éliminer ledit masque dur (40, 42) et la partie de la couche de transfert (26) située dans ladite zone (44), et à évider la partie de la couche d'évidement située sous ladite zone de sorte que lesdits objets soient suspendus,

la vitesse d'attaque de gravure de ladite couche d'évidement étant supérieure à la vitesse d'attaque de gravure de la couche de transfert et du masque dur. Application à la caractérisation, notamment mécanique, d'objets sub - micrométriques et des matériaux les constituant.

## Description

La présente invention a pour objet un procédé de fabrication d'objets suspendus sub-micrométriques et des composants microélectroniques fabriqués selon ledit procédé. L'invention concerne également la détermination d'au moins une propriété de ces objets ou du matériau les constituant.

En microélectronique on utilise des microcircuits de dimensions de plus en plus réduites. Outre un encombrement plus faible, cette miniaturisation permet de diminuer la consommation électrique et d'augmenter la rapidité des circuits. Les technologies actuellement utilisées en microélectronique permettent de réaliser des éléments de microcircuit, tels que des connexions de composants, de dimensions sub-micrométriques. Dans la présente demande, on désigne par objet "sub-micrométrique" ou "nanométrique" un objet ayant des dimensions inférieures à quelques micromètres (µm), généralement de l'ordre de quelques centaines de nanomètres (compris par exemple entre 50 et 300 nanomètres), à l'exception cependant d'une dimension (en général sa longueur) qui peut, mais non nécessairement, être supérieure à quelques µm. Par exemples, un objet sub-micrométrique de forme parallélépipédique rectangle aura une largeur et une hauteur en général inférieures à un µm, de l'ordre de quelques centaines de nanomètres, et une longueur pouvant dépasser quelques µm et un objet de forme cylindrique aura une section droite de diamètre inférieur à un µm, par exemple quelques centaines de nanomètres, et une longueur pouvant dépasser plusieurs µm.

Du fait de leur petite taille, ces objets sub-micrométriques sont réalisés sur un support, généralement un semi-conducteur, ou sur une couche isolante, par exemple une couche d'oxyde ou de nitrure de silicium, elle-même déposée sur un support. Si leurs propriétés électriques peuvent être déterminées relativement aisément, la détermination des propriétés mécaniques de ces objets ou des matériaux les constituant n'a jusqu'à ce jour pas pu être réalisée de façon satisfaisante. Par exemple, le procédé publié par Michael D. Uchic, Dennis M. Dimiduk, Jeffrey N. Florando, William D. Dix dans l'article intitulé "Sample dimensions influence strength and crystal plasticity" ("les dimensions d'un échantillon influencent la résistance et la plasticité cristalline"), publié le 13 août 2004 dans la revue Science, Vol 305, Pages 986-989, consiste à découper à l'aide d'un faisceau d'ions (technique "FIB" qui est l'abréviation de "Focused Ion Beam") un cylindre sub-micrométrique de diamètre compris entre 100 et 200 nm dans une couche mince du matériau dont on veut déterminer les propriétés mécaniques. A l'aide d'une pointe d'indentation, on appuie sur le dessus du cylindre et on mesure le déplacement de la pointe en fonction de la force exercée. Cette technique présente l'inconvénient de ne pas réellement représenter les caractéristiques du matériau à l'échelle sub-micrométrique puisque le cylindre testé n'a pas été fabriqué avec les dimensions sub micrométriques mais découpé dans une couche de beaucoup plus grande dimension, de l'ordre du cm par exemple. Lorsque l'on passe à des dimensions sub-micrométriques, des phénomènes physiques nouveaux apparaissent, qui n'existent pas à une plus grande échelle. Il en résulte des propriétés mécaniques différentes. Or il est important de caractériser mécaniquement et électriquement les objets sub-micrométriques de façon à ajuster leurs procédés de fabrication, tels que par exemple la composition du ou des matériaux de fabrication de ces objets, l'interfaçage de composants ou les procédés de nettoyage et de recuit des composants. La connaissance des propriétés mécaniques des objets sub-micrométriques permet de concevoir des procédés de fabrication microélectronique de ces objets, tels que les puces et autres composants microélectroniques et d'améliorer la fiabilité de ces composants et des microcircuits.

La présente invention apporte une solution à ce problème en proposant un procédé de fabrication d'objets sub-micrométriques de telle sorte que ces objets soient suspendus. La caractérisation des propriétés mécaniques et électriques des objets est réellement représentative des propriétés à l'échelle sub-micrométrique puisque ces objets sont fabriqués à cette échelle et ne reposent plus, au moins en partie, sur un support. De plus, les objets sont parfaitement isolés électriquement puisqu'ils sont entourés d'air.

De façon plus précise, la présente invention propose un procédé de fabrication d'objets sub-micrométriques qui comporte les étapes suivantes :
- dépôt d'une couche d'évidement sur un support,
- dépôt d'une couche de transfert sur ladite couche d'évidement,
- réalisation desdits objets dans ladite couche de transfert,
- réalisation d'un masque dur sur une partie de ladite couche de transfert afin de délimiter une zone comprenant une partie desdits objets, et
- gravure de l'ensemble formé par ledit masque dur, la couche de transfert et la couche d'évidement de façon à éliminer ledit masque dur et la partie de la couche de transfert située dans ladite zone, et à évider la partie de la couche d'évidement située sous ladite zone de sorte que lesdits objets soient suspendus,
la vitesse d'attaque de gravure de ladite couche d'évidement étant supérieure à la vitesse d'attaque de gravure de la couche de transfert et du masque dur.

La vitesse d'attaque de gravure de la couche d'évidement est avantageusement supérieure d'un ordre de grandeur à I vitesse d'attaque de gravure de la couche de transfert et du masque dur.

Selon un mode de réalisation avantageux :
- la couche d'évidement est réalisée en oxyde de silicium dopé au bore ou au phosphore et son épaisseur est supérieure à un µm, de préférence de l'ordre de trois µm;
- la couche de transfert est réalisée en oxyde de silicium ou en nitrure de silicium;
- lesdits objets sont à structure métallique et la réalisation des objets dans la couche de transfert comporte une gravure de la couche de transfert selon la forme desdits objets, un dépôt d'une couche métallique sur la couche de transfert gravée et un polissage de ladite couche métallique; et
- ledit masque dur réalisé sur une partie de la couche de transfert est obtenu par dépôt d'une couche de nitrure de silicium ou d'oxyde de silicium sur la couche de transfert dans laquelle les objets ont été formés et par dépôt d'une couche de résine sur ladite couche de nitrure en dehors de ladite zone, ladite couche de résine délimitant ladite zone.

Selon un autre mode de réalisation, une couche d'accrochage peut, mais non obligatoirement, être déposée sur la couche de transfert gravée avant le dépôt de la couche métallique, ladite couche d'accrochage étant par exemple en tantale ou en titane.

Selon un mode de réalisation particulier, lesdits objets forment un ensemble de poutres métalliques sensiblement parallèles entre elles et suspendues à au moins l'une de leurs deux extrémités. Lesdites poutres sont situées dans ladite zone et la suspension des poutres est située en dehors de ladite zone.

Le support de la couche d'évidement est avantageusement un semi-conducteur.

La présente invention concerne aussi des composants microélectroniques fabriqués selon ledit procédé, ces composants comportant au moins une partie sub-micrométrique suspendue.

La présente invention propose également, en application dudit procédé, la caractérisation, notamment mécanique, d'objets métalliques sub micrométriques ou du matériau constituant lesdits objets de dimensions sub micrométriques. A cette fin, au moins une poutre sub -micrométrique suspendue en au moins l'une de ses deux extrémités est fabriquée selon ledit procédé et des tests sont effectués sur ladite poutre afin de caractériser au moins une propriété mécanique de la poutre ou du matériau la constituant. La propriété mécanique peut être par exemple le module d'Young ou la limite d'élasticité. La caractérisation mécanique est avantageusement effectuée par une technique de nano-indentation.

Bien entendu, les propriétés électriques des objets sub-micrométriques peuvent être déterminées. Ces objets étant suspendus et donc en partie entourés d'air, leurs caractéristiques électriques peuvent être différentes des mêmes objets reposant sur un support isolant.

D'autres avantages et caractéristiques de l'invention apparaîtront au cours de la description qui suit de plusieurs modes de réalisation de l'invention, donnés à titre d'exemples non limitatifs, en référence aux dessins annexés et sur lesquels :

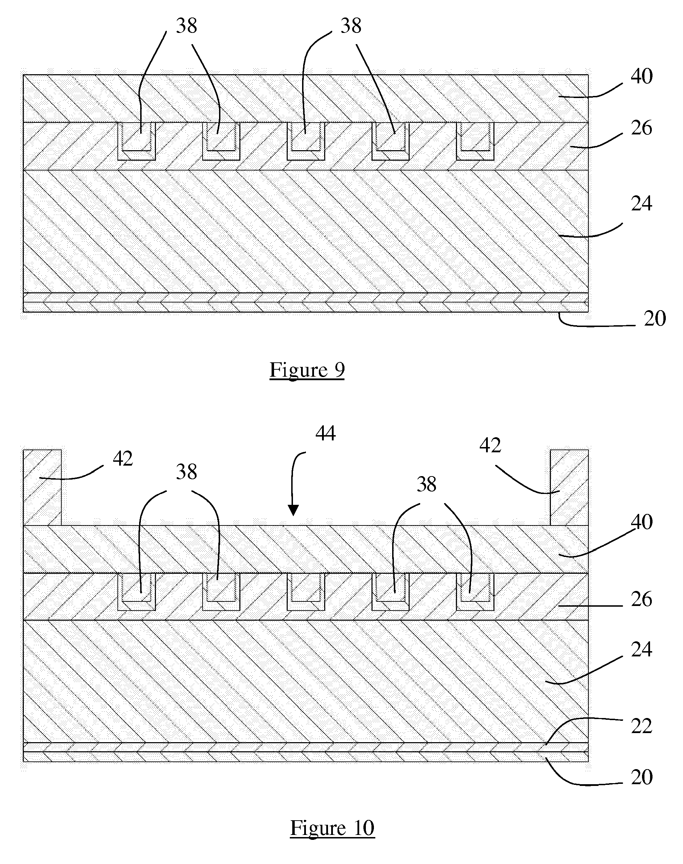

- les figures 1 à 12 illustrent les étapes du procédé de fabrication d'objets sub-micrométriques suspendus,
- la figure 13 montre en détail une partie de l'un des objets obtenus par la mise en oeuvre du procédé illustré sur les figures précédentes, et
- la figure 14 montre un autre exemple d'objet sub-micrométrique suspendu obtenu à l'aide du procédé de l'invention.

Le procédé qui va être décrit concerne la fabrication d'un ensemble d'objets sub-micrométriques suspendus, plus précisément un ensemble de poutres parallèles encastrées à leurs deux extrémités.

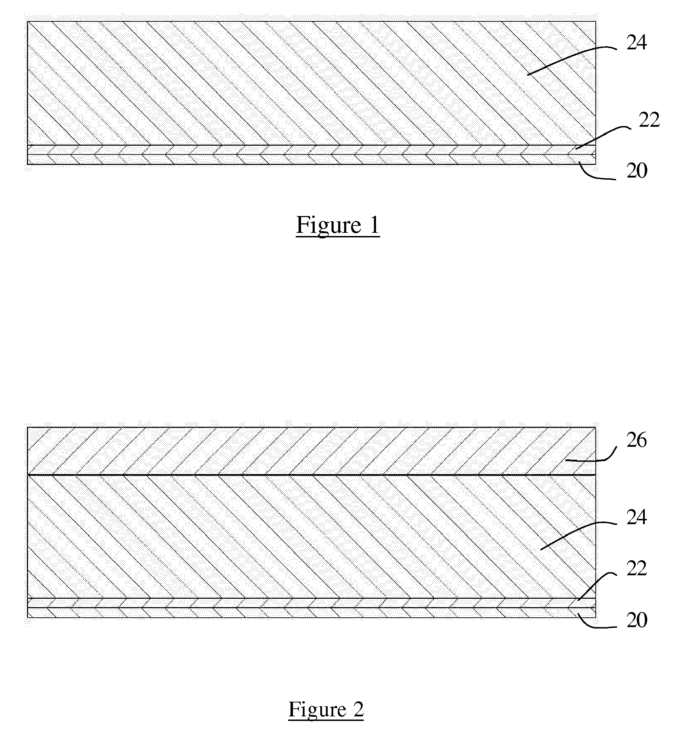

Comme illustré sur la figure 1, on part d'un support 20 constitué d'une galette de silicium de diamètre standard 200 ou 300 mm. Cette galette peut être préalablement nettoyée, par un procédé classique. Un film intermédiaire 22, constitué d'une couche de nitrure de silicium d'épaisseur environ 50 à 100 nm, est avantageusement (mais non obligatoirement) déposé sur la galette 20 de façon à augmenter la rigidité de la galette et ainsi à réduire les risques de contraintes mécaniques dus au dépôt de la couche suivante.

Une couche d'évidement 24 est ensuite déposée sur la couche 22. La couche d'évidement a une épaisseur relativement importante, supérieure à un µm et de préférence voisine de deux ou trois µm. Cette épaisseur est ajustée en fonction notamment de l'épaisseur des poutres à réaliser et de la vitesse d'attaque de gravure de la couche d'évidement. Comme indiqué par la suite, le matériau de cette couche est choisi de telle sorte que lorsqu'il est gravé, par un procédé classique de lithogravure par exemple, la vitesse d'attaque de gravure est supérieure à celle des autres matériaux utilisés dans la mise en oeuvre du procédé (de préférence d'un ordre de grandeur, donc sensiblement dix fois plus rapide). En d'autres termes, pendant une opération de gravure, la quantité de matière éliminée de la couche d'évidement est supérieure à la quantité de matière éliminée des autres couches. La couche d'évidement 24 est de préférence réalisée en oxyde de silicium dopé au bore, ou tout autre dopant dont la particularité est d'augmenter la vitesse d'attaque de gravure du matériau, par exemple le phosphore.

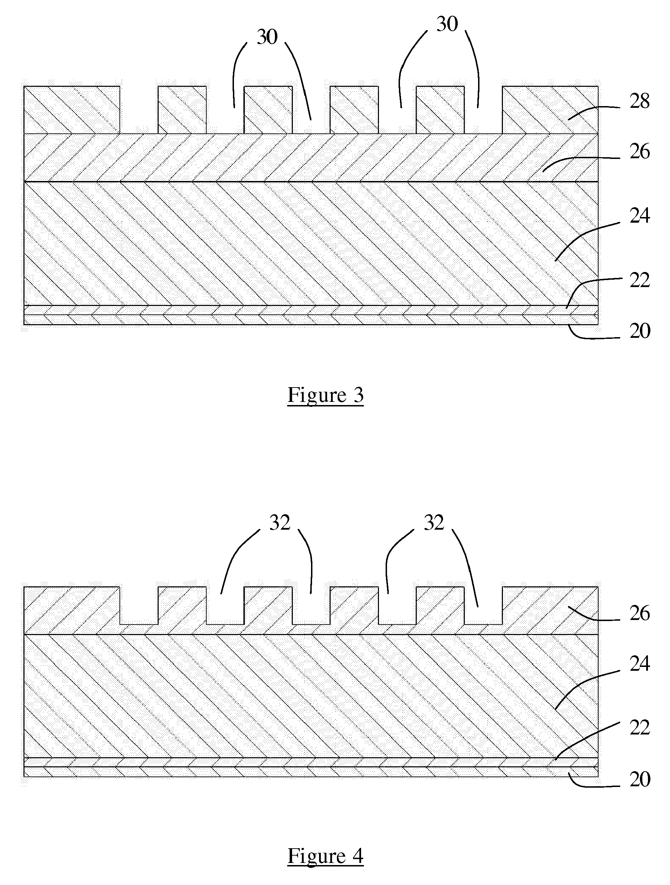

Une couche de transfert 26, réalisée en oxyde de silicium ou en nitrure de silicium et d'épaisseur voisine de 400 nm, est ensuite déposée sur la couche d'évidement 24 (figure 2). On procède ensuite à la réalisation des objets dans cette couche de transfert 26. Pour ce faire, un masque de résine 28 (figure 3) est déposé sur la couche de transfert 26. Les parties en creux 30 de ce masque épousent la forme des objets à fabriquer. Par un procédé classique de lithographie (figure 4), la couche de transfert 26 est gravée ce qui reproduit la forme du masque dans la couche de transfert 26 et la couche de résine 28 est éliminée. Pour la fabrication de poutres parallèles, les creux 32 forment un réseau de rainures parallèles de forme sensiblement parallélépipédique rectangle. La largeur des rainures correspond à la largeur désirée des poutres. On utilise de préférence un procédé de lithographie à rayonnement ultraviolet de courte longueur d'onde (par exemple 248 nm) afin d'obtenir une précision suffisante pour les dimensions des poutres. A titre d'exemple, ces dimensions peuvent être approximativement les suivantes largeur 200 nm, épaisseur 400 nm et longueur 6 µm environ.

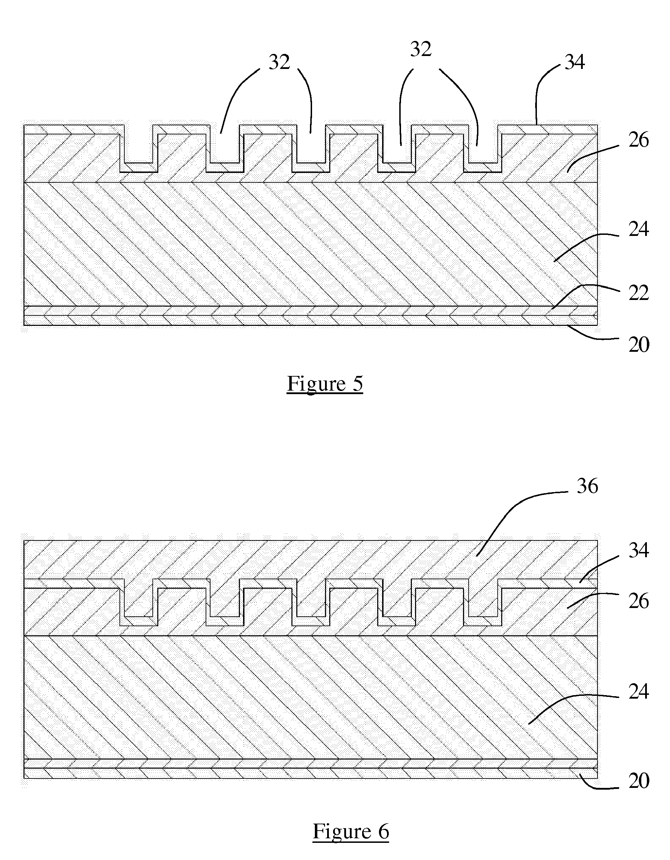

Une couche d'accrochage 34 (figure 5) est ensuite avantageusement (mais non obligatoirement) déposée sur la couche de transfert gravée 26. La présence de cette couche d'accrochage permet de réaliser des objets sub micrométriques dans une large gamme de matériaux différents, notamment dans pratiquement tout type de métaux. Le matériau utilisé pour la couche d'accrochage 34 dépend du matériau des objets à réaliser. Par exemple, elle peut être en tantale si les objets sont en cuivre ou en titane si les objets sont en tungstène. L'épaisseur de la couche d'accrochage 34 est très faible par rapport à l'épaisseur des objets (à titre d'exemple, quelques dizaines de nanomètres comparé à quelques centaines de nanomètres).

Une couche 36, réalisée en matériau constituant les objets submicrométriques, est déposée (figure 6) sur la couche de transfert gravée de façon à remplir complètement les rainures 32. Lorsque l'on souhaite étudier les caractéristiques des interconnexions sub-micrométriques en cuivre des microcircuits, le matériau de la couche 36 est du cuivre. Le dépôt peut être effectué par une méthode classique, par exemple PVD, CVD ou ECD, désignant successivement "Plasma Vapor Deposition" (déposition par vapeur plasma), "Chemical Vapor Deposition" (déposition par vapeur chimique), et "Electro Chemical Deposition" (déposition électrochimique). Dans le cas du cuivre, le dépôt peut être réalisé par voie électrochimique, par exemple dans un bain d'électrolyte à base d'acide sulfurique. De façon générale, la couche 36 est réalisée en un matériau dont on souhaite obtenir des objets sub-micrométriques, par exemple en un matériau métallique ou isolant si l'on souhaite réaliser des objets sub-micrométriques respectivement métalliques ou isolants.

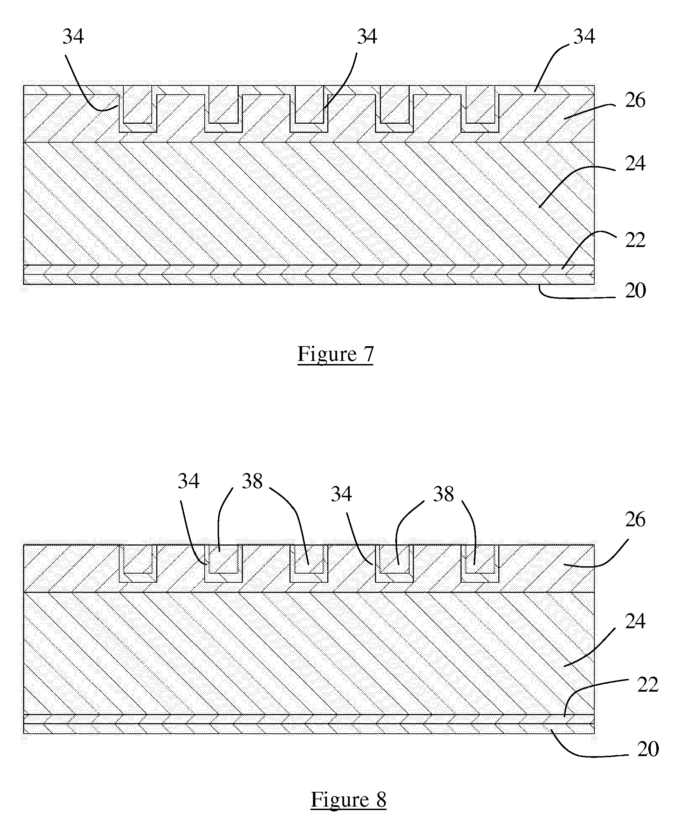

Un polissage est ensuite effectué (figure 7) pour enlever l'excédent de matériau déposé dans l'étape précédente. Lorsqu'une couche d'accrochage 34 est utilisée, l'enlèvement du matériau par les procédés classiques de polissage s'arrête à la couche d'accrochage 34 que l'on enlève ensuite (figure 8) par une nouvelle opération de polissage, à l'exception des parties de couche d'accrochage tapissant les parois des rainures 32. Lorsqu'une couche d'accrochage n'est pas utilisée, l'opération de polissage est arrêtée au niveau de la couche de transfert 26. Au lieu d'un polissage, l'enlèvement de l'excédent de matériau et de la couche d'accrochage peut être effectué par gravure. Les objets sub-micrométriques, plus précisément des poutres 38, sont ainsi réalisés. Cependant, à ce stade, les objets 38 ne sont pas suspendus. La suspension des objets est le but poursuivi par les étapes suivantes du procédé.

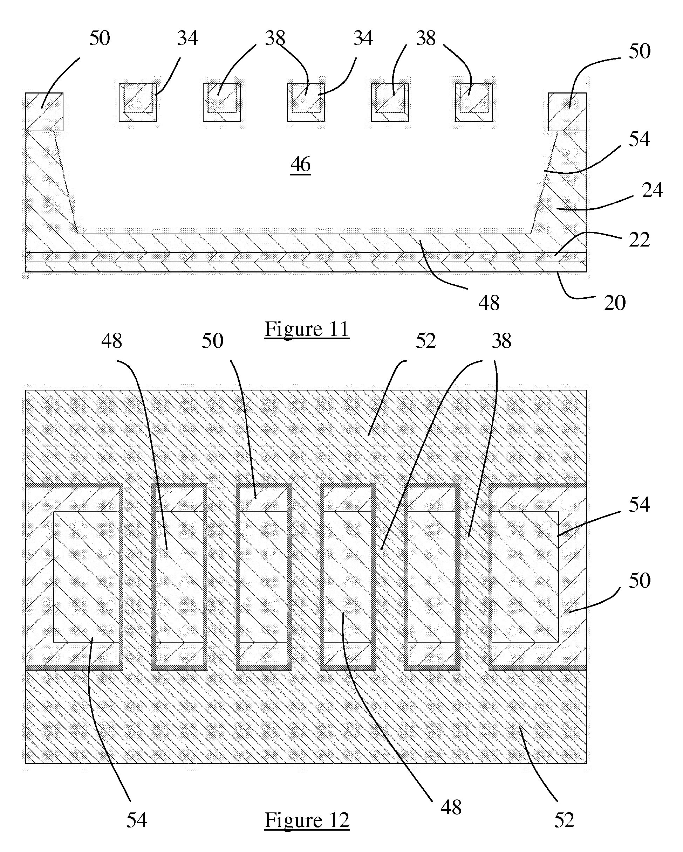

Un masque dur est réalisé au-dessus de la couche de transfert 26. Ce masque se compose d'une part d'une couche 40, de préférence en nitrure de silicium ou en oxyde de silicium, déposée sur la couche de transfert 26 et sur les objets 38 et, d'autre part, d'un dépôt de résine 42. Ce dernier est situé au-dessus des parties de la couche de transfert 26 que l'on souhaite conserver pendant l'opération de gravure qui suit et au-dessus de la partie des objets qui reste supportée par la couche de transfert 26 après ladite opération de gravure. En d'autres termes, la partie de la couche 40 non recouverte de résine 42 délimite une zone 44 située au-dessus de la partie suspendue des objets 38. Par lithogravure, on forme l'image de la cavité 46 (figure 11) formée à l'étape suivante. Pour cette lithogravure, un rayonnement ultraviolet de longueur d'onde moyenne (par exemple 365 nm) peut être utilisé puisque des cavités de l'ordre de la dizaine de µm sont réalisées et donc la précision requise à l'étape du procédé illustré sur la figure 3 n'est pas nécessaire.

On procède ensuite (figures 11 et 12) à l'évidement de la partie de la couche d'évidement 24 située sous la zone 44. Cette opération est effectuée en exposant l'ensemble constitué par les différentes couches 22, 24, 26, 40 et 42 et par les objets 38 à une combinaison de gravures sèche et humide. La gravure sèche a pour caractéristique d'être une attaque dont on peut contrôler la direction de gravure. Ladite gravure permet de réaliser une attaque anisotrope ou isotrope. L'attaque anisotrope permet d'effectuer la gravure dans le sens vertical uniquement, tandis que l'attaque isotrope permet de graver dans l'ensemble des directions, notamment en profondeur et latéralement. L'évidage sous les objets est finalisé par l'utilisation d'une gravure humide, qui elle est isotrope. C'est donc une combinaison des deux types de gravure qui permet l'ouverture de la cavité et la mise en suspension des objets.

Le but est de réaliser une cavité 46 et ainsi d'obtenir un ensemble de poutres suspendues à leurs deux extrémités. La cavité doit être suffisamment importante pour bien isoler mécaniquement et électriquement la partie suspendue des objets de la partie restante 48 de la couche d'évidement et de ne laisser aucun résidu dans cette cavité. Le masque dur composé des couches 40 et 42 et la couche de transfert 26 disparaissent, à l'exception des parties restantes 50 de la couche de transfert 26 (parties situées sous la résine 42). Ces parties restantes 50 servent de support à la partie non suspendue 52 des objets 38 et ne doivent donc pas être endommagées par l'étape de gravure. Cette dernière est arrêtée lorsqu'il reste une faible épaisseur 48 de couche d'évidement au fond de la cavité 46, de façon à ce que la gravure n'attaque pas le film intermédiaire 22, ou le support 20 lorsqu'il n'y a pas de film intermédiaire. Les bords 54 de la couche d'évidement doivent aussi être conservés.

Afin de former la cavité 46, tout en éliminant le masque dur composé des couches 40 et 42 et la couche de transfert 26 (à l'exception des parties restantes 50), la vitesse d'attaque de gravure de la couche d'évidement 24 doit être supérieure à la vitesse d'attaque de gravure des couches 26, 40 et 42 et les objets 38 doivent être protégés. La protection des objets se fait naturellement par le choix de la gravure qui est fait pour obtenir une attaque des couches citées, à l'exception des objets. A titre d'exemple, la différence de vitesses d'attaque de gravure est d'un ordre de grandeur. Autrement dit la vitesse d'attaque de gravure de la couche d'évidement 24 est approximativement dix fois supérieure à la vitesse d'attaque de gravure des couches 26, 40 et 42. On a donc un retard de gravure de ces couches par rapport à la couche d'évidement. La différence de vitesses d'attaque de gravure est déterminée en fonction des matériaux utilisés pour les différentes couches, de l'épaisseur de ces couches et de la hauteur de la cavité 46 que l'on souhaite obtenir.

La partie suspendue des objets peut être protégée de la corrosion en injectant un produit anticorrosion dans la cavité 46 à la fin de l'étape de gravure.

A titre d'exemple, l'opération de gravure peut être effectuée de la façon suivante. On peut tout d'abord procéder à une gravure plasma sèche en deux étapes.

La première étape consiste à graver de façon anisotrope la couche de nitrure 40 avec une composition fluorée, par exemple du CHF₃.

Ladite première étape grave verticalement la couche 40 de la zone 44 à travers le masque de résine 42, ladite résine 42 étant développée par procédé photolithographique, la couche 26 située sous la couche 40 et la couche 24 située sous la couche 26, jusqu'à atteindre la profondeur souhaitée de la cavité 46 afin de ne pas attaquer les couches 22 et 20.

A la fin de cette étape, les parties des couches 40, 26 et 24 situées verticalement sous la couche 42 sont conservées.

La seconde étape de gravure à caractère isotrope a pour but de graver en profondeur et latéralement la couche 42, la couche 40 située sous la couche 42, et notamment les couches 24 et 26 situées sous les objets 38.

Ladite seconde étape peut être réalisée avec un mélange de gaz fluorés, par exemple un mélange de CHF₃ et de C₂F₆.

L'étape supplémentaire de gravure humide isotrope doit être de courte durée pour préserver les parties restantes 50 de la couche 26 servant de support à la partie non suspendue 52 des objets 38. Ladite étape supplémentaire permet de terminer le retrait des oxydes qui n'ont pas été gravés par plasma, en particulier sous les objets 38 de grande taille. Pour cela on peut utiliser une chimie à base d'acide fluorhydrique (HF) diluée de préférence dans du fluorure d'ammonium (NH₄OH). La dilution doit être suffisante pour obtenir une vitesse d'attaque significative mais pas excessive. Le composé désigné par BE 7 :1 (pour "Buffered Etchant") a donné un bon compromis. La dilution peut cependant être un peu plus élevée. Dans le cas d'objets 38 sensibles aux phénomènes de corrosion, une injection chimique peut être ajoutée en fin de procédé pour les protéger. Dans le cas d'objet en cuivre, une injection de BTA (benzothiazole) peut être utilisée.

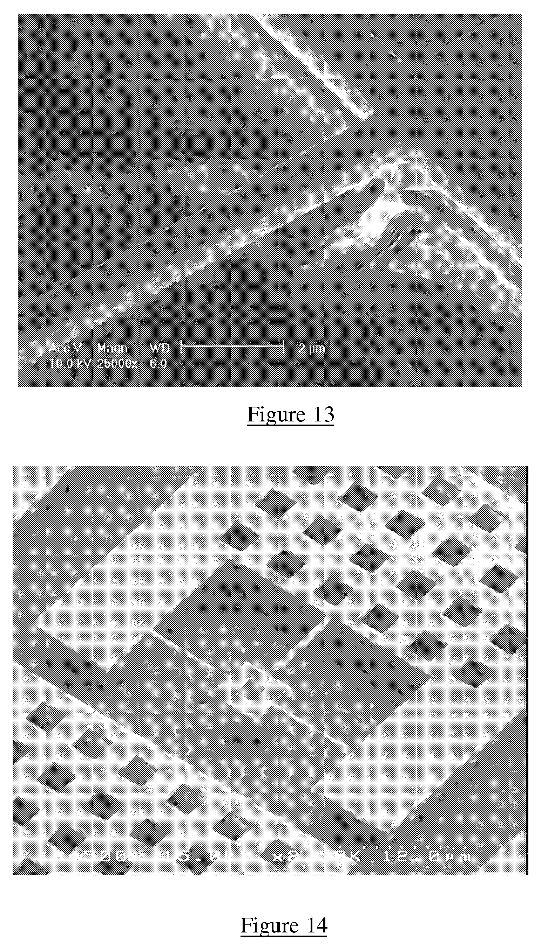

La figure 13 est une photographie prise au microscope électronique d'une partie d'une poutre suspendue. On distingue nettement la partie suspendue et son point d'ancrage. La largeur de la poutre photographiée est d'environ 200 nm et son épaisseur est approximativement de 400 nm.

L'exemple de réalisation qui vient d'être décrit concerne la réalisation simultanée d'un ensemble de poutres suspendues à leurs deux extrémités. Il est aisé d'imaginer que ces poutres pourraient n'être encastrées qu'à une seule de leurs extrémités, simplement en ajustant la géométrie du masque dur composé de la couche 40 et de la résine 42. De même, une seule poutre pourrait être réalisée.

Des formes différentes d'objets sub-micrométriques sont aisément concevables. Il suffit pour cela d'adapter le masque de la couche 28 (figure 3) à la forme souhaitée. Par exemple, un mode particulier de structure suspendue est montré sur la photographie de la figure 14, laquelle représente un carré évidé en son centre et suspendu à l'aide de trois bras de dimensions sub-micrométriques (à l'exception de leurs longueurs), eux-mêmes suspendus à un support. Cette structure convient par exemple pour effectuer des essais de traction.

La présente invention a donc également pour objet tout type de composants microélectroniques fabriqués selon le procédé décrit précédemment, ces composants comprenant une partie sub -micrométrique suspendue.

Le procédé de l'invention est intéressant, non seulement pour fabriquer des objets sub-micrométriques suspendus, mais aussi pour déterminer les caractéristiques mécaniques et électriques de ces objets et des matériaux les constituant. Le fait que ces objets soient suspendus permet de tester certaines de leurs propriétés mécaniques non accessibles sans la présente invention, par exemple leur module d'Young et leur élasticité (en particulier leur limite d'élasticité). De plus, ces objets suspendus sont isolés électriquement, au moins en partie, par l'air qui les entoure. Or l'air est un meilleur isolant électrique que les isolants classiques (oxyde de silicium ou nitrure de silicium) sur lesquels reposent habituellement ces objets : leurs propriétés électriques devraient donc être différentes. A titre d'exemple, si l'objet sub-micrométrique est une poutre suspendue encastrée à ses deux extrémités, qui peut être en réalité une interconnexion en cuivre entre deux composants d'un circuit microélectronique, l'invention permet de tester les propriétés mécaniques de cette interconnexion, et donc les propriétés mécaniques du cuivre à ces dimensions sub-microscopiques. De plus, l'invention permet d'accéder aux propriétés électriques d'une telle interconnexion, et donc du cuivre, à l'échelle sub-micrométrique.

Les propriétés mécaniques et électriques sont déterminées par les méthodes classiques utilisées en microélectronique. Par exemple, pour mesurer le module d'Young et l'élasticité, on fabrique une ou plusieurs poutres suspendues à leurs deux extrémités. Une pointe de nano-indentation est déposée au centre de la poutre. La pointe appuie sur la poutre et on mesure son déplacement en fonction de la force appliquée. On peut également repérer la force appliquée pour laquelle il y a rupture de la poutre. On peut aussi déterminer la limite d'élasticité qui correspond au moment où le matériau mis sous contrainte ne revient plus à son état initial et se déforme.

Le mode de réalisation représenté sur la figure 14 permet par exemple de déterminer les propriétés mécaniques d'un composant suspendu par des bras sub-micrométriques en effectuant des essais de traction sur le composant et de flexion des bras.

L'invention ouvre des champs nouveaux en microélectronique puisqu'elle permet par exemple de réaliser des structures microélectroniques nouvelles, telles que des structures capacitives ou mettre en regard deux fils métalliques sub-micrométriques isolés par de l'air uniquement. A partir de ces objets sub-micrométriques suspendus, tels qu'une poutre par exemple, on peut concevoir aisément des microsystèmes tels que des capteurs pour mesurer par exemple des accélérations, des pressions, des vibrations ou des températures.

## Revendications

1. Procédé de fabrication d'objets sub-micrométriques, **caractérisé en ce qu'**il comporte les étapes suivantes :
- dépôt d'une couche d'évidement (24) sur un support (20),
- dépôt d'une couche de transfert (26) sur ladite couche d'évidement (24),
- réalisation desdits objets (38) dans ladite couche de transfert,
- réalisation d'un masque dur (40, 42) sur une partie de ladite couche de transfert (26) afin de délimiter une zone (44) comprenant une partie desdits objets, et
- gravure de l'ensemble formé par ledit masque dur, la couche de transfert et la couche d'évidement de façon à éliminer ledit masque dur (40, 42) et la partie de la couche de transfert (26) située dans ladite zone (44), et à évider la partie de la couche d'évidement située sous ladite zone de sorte que lesdits objets soient suspendus,
la vitesse d'attaque de gravure de ladite couche d'évidement étant supérieure à la vitesse d'attaque de gravure de la couche de transfert et du masque dur.

2. Procédé selon la revendication 1 **caractérisé en ce que** la vitesse d'attaque de gravure de la couche d'évidement (24) est supérieure d'un ordre de grandeur à la vitesse d'attaque de gravure de la couche de transfert (26) et du masque dur (40, 42).

3. Procédé selon l'une des revendications précédentes **caractérisé en ce que** la couche d'évidement (24) est réalisée en oxyde de silicium dopé avec un matériau augmentant la vitesse d'attaque de gravure de ladite couche d'évidement.

4. Procédé selon la revendication 3 **caractérisé en ce que** la couche d'évidement (24) est dopée avec du bore ou du phosphore.

5. Procédé selon l'une des revendications précédentes **caractérisé en ce que** l'épaisseur de la couche d'évidement (24) est supérieure à un µm.

6. Procédé selon l'une des revendications précédentes **caractérisé en ce que** lesdits objets (38) sont à structure métallique et **en ce que** ladite réalisation desdits objets dans la couche de transfert (26) comporte les étapes suivantes :
- gravure de la couche de transfert selon la forme desdits objets,
- dépôt d'une couche métallique (36) sur la couche de transfert gravée, et
- polissage de ladite couche métallique.

7. Procédé selon la revendication 6 **caractérisé en ce que** la gravure de la couche de transfert (26) est réalisée par lithogravure.

8. Procédé selon l'une des revendications précédentes **caractérisé en ce que** la couche de transfert (26) est réalisée en oxyde de silicium ou en nitrure de silicium.

9. Procédé selon l'une des revendications 6 à 8 **caractérisé en ce qu'**une couche d'accrochage (34) est déposée sur la couche de transfert gravée avant le dépôt de la couche métallique.

10. Procédé selon la revendication 9 **caractérisé en ce que** ladite couche d'accrochage (34) est en tantale ou en titane.

11. Procédé selon l'une des revendications précédentes **caractérisé en ce que** ledit masque dur réalisé sur une partie de la couche de transfert est obtenu par dépôt d'une couche de nitrure de silicium ou d'oxyde de silicium (40) sur la couche de transfert (26) dans laquelle les objets (38) ont été formés et dépôt d'une couche de résine (42) sur ladite couche de nitrure en-dehors de ladite zone (44), ladite couche de résine délimitant ladite zone.

12. Procédé selon l'une des revendications précédentes **caractérisé en ce que** lesdits objets (38) forment un ensemble de poutres métalliques sensiblement parallèles entre elles et suspendues à au moins l'une de leurs deux extrémités.

13. Procédé selon la revendication 12 **caractérisé en ce que** la partie suspendue desdites poutres est située dans ladite zone (44) et la suspension desdites poutres est située en dehors de ladite zone.

14. Procédé selon l'une des revendications précédentes **caractérisé en ce que** ledit support (20) est un semi-conducteur.

15. Procédé selon l'une des revendications précédentes **caractérisé en ce qu'**un film intermédiaire (22) est déposé entre le support (20) et la couche d'évidement (24).

16. Composant microélectronique fabriqué selon le procédé défini à au moins l'une des revendications précédentes **caractérisé en ce qu'**il comporte au moins une partie sub-micrométrique suspendue

17. Application du procédé défini à l'une des revendications 1 à 15 à la détermination d'au moins une propriété d'un objet sub-micrométriques ou du matériau constituant ledit objet de dimensions submicrométriques.

18. Application selon la revendication 17 **caractérisée en ce qu'**au moins une poutre sub-micrométrique suspend ue en au moins l'une de ses deux extrémités est fabriquée selon ledit procédé et **en ce que** des tests sont effectués sur ladite poutre afin de caractériser au moins une propriété mécanique de la poutre ou du matériau la constituant.

19. Application selon la revendication 18 **caractérisée en ce que** l'on détermine au moins le module d'Young, l'élasticité ou la limite d'élasticité.

20. Application selon l'une des revendications 17 à 19 **caractérisée en ce que** ladite caractérisation mécanique est effectuée par une technique de nano-indentation.
